**Europäisches Patentamt**

**European Patent Office**

**Office européen des brevets**

(19)

(11) Veröffentlichungsnummer: **0 215 146 B1**

(12) **EUROPÄISCHE PATENTSCHRIFT**

(45) Veröffentlichungstag der Patentschrift:
**03.08.88**

(21) Anmeldenummer: **85111700.2**

(22) Anmeldetag: **16.09.85**

(51) Int. Cl.⁴: **G 01 R 1/073**

(54) Vorrichtung zum elektronischen Prüfen von Leiterplatten oder dergleichen.

(43) Veröffentlichungstag der Anmeldung:
**25.03.87 Patentblatt 87/13**

(45) Bekanntmachung des Hinweises auf die Patenterteilung:
**03.08.88 Patentblatt 88/31**

(84) Benannte Vertragsstaaten:
**AT BE CH DE FR GB IT LI LU NL SE**

(56) Entgegenhaltungen:
**DE - A - 3 337 915**
**US - A - 4 164 704**

(73) Patentinhaber: **MANIA Elektronik Automatisation Entwicklung und Gerätebau GmbH, Technologiepark, D-6395 Wellrod 8 (DE)**

(72) Erfinder: **Mang, Paul, Weilbergstrasse 4, D-6384 Schmitten 2 (DE)**
Erfinder: **Krause, Edmund, Wiesenau 13, D-6384 Schmitten 8 (DE)**
Erfinder: **Driller, Hubert, Altkönigstrasse 11, D-6384 Schmitten 3 (DE)**

(74) Vertreter: **Ruschke, Hans Edvard et al, Patentanwälte Dipl.-Ing. Olaf Ruschke Dipl.-Ing. Hans E. Ruschke Dipl.-Ing. Jürgen Rost Dipl.-Chem. Dr. U. Rotter Pienzenauerstrasse 2, D-8000 München 80 (DE)**

## Beschreibung

Die Erfindung betrifft eine Vorrichtung zum elektronischen Prüfen von Leiterplatten oder dergleichen nach dem Oberbegriff des Patentanspruches 1.

Aus der DE-A- 2 933 862 geht eine Vorrichtung zum elektronischen Prüfen von Leiterplatten hervor, die in sich federnde Prüfstifte aufweist, die elektrische Verbindungen zwischen einem rastergebundenen Kontaktfeld und einer gegen die Vorrichtung gedrückten Leiterplatte herstellen. Jede dem Kontaktfeld zugewandte Spitze eines Prüfstiftes greift dabei in einen Führungskanal der das Kontaktfeld aufweisenden Anordnung ein und liegt im Führungskanal an einem starren Gegenkontakt an, der über eine Verbindungsleitung mit der elektroischen Prüfeinrichtung verbunden ist. An der Seite der zu prüfenden Leiterplatten weisen die Prüfstifte in Längsrichtung federnde Kontaktspitzen auf, die in bestimmte Durchkontaktierungen der gegen die Vorrichtung gedrückten Leiterplatte zur Kontaktherstellung eingreifen.

Probleme derartiger Prüfstifte bestehen darin, dass sie zum einen auf Grund der vorgesehenen federnden Kontaktspitzen relativ kompliziert und teuer sind und dass sie zum anderen in radialer Richtung gesehen im Bereich der federnden Kontaktspitzen einen relativ grossen Durchmesser aufweisen. Dies ist insbesondere im Hinblick darauf von Nachteil, dass auf Grund der zunehmenden Komplexität der Leiterplatten diese bereichsweise Anschlussdichten aufweisen, die grösser sind als die mittlere Anschlussdichte im Grundraster des Kontaktfeldes. Infolge der verhältnismässig grossen Durchmesser der Prüfspitzen im Bereich der federnden Kontaktspitzen sind daher der Anpassung an grössere Anschlussdichten Grenzen gesetzt.

Es sind auch Vorrichtungen bzw. Adapter bekannt, bei denen die einzelnen Prüfstifte keine federnden Kontaktspitzen aufweisen und bei denen stattdessen die einelnen Kontaktelemente des rastergebundenen Kontaktfeldes federnd ausgebildet sind. Ein Problem besteht dabei jedoch darin, dass die federlosen Prüfstifte in der Längrichtung einen nicht konstanten Durchmesser bzw. eine Kontur aufweisen müssen, damit sie in der Vorrichtung in Längsrichtung festgelegt werden. Die erforderliche Kontur kann beispielsweise dadurch erreicht werden, dass der Durchmesser der Prüfspitzen in vorbestimmten Bereichen vergrössert wird. Dies führt jedoch dazu, dass der Anpassung an grössere Anschlussdichten an der Seite der Leiterplatte Grenzen gesetzt sind. Andererseits kann die erforderliche Kontur auch dadurch erreicht werden, dass in bestimmten Bereichen der Prüfspitzen der Durchmesser verkleinert ist. Dadurch wird jedoch eine geringere Stabilität der Prüfspitzen bewirkt.

Aus der US-A-4 146 704 geht ein weiterer Adapter mit in sich federnden Prüfstiften hervor, die elektrische Verbindungen zwischen einem Kontaktfeld und einer Leiterplatte herstellen. Bei dieser Vorrichtung wird jeder Kopf eines federnden Prüfstiftes durch eine flexible Kunststoffschicht in Bezug auf die anderen Prüfstiftköpfe in der richtigen Position gehalten.

Die Aufgabe der vorliegenden Erfindung besteht darin, eine Vorrichtung der eingangs genannten Art derart auszubilden, dass sowohl federlose als auch in der Längsrichtung einen konstanten Durchmesser aufweisende Prüfstifte verwendbar sind.

Diese Aufgabe wird durch eine wie eingangs genannte Vorrichtung zum elektronischen Prüfen von Leiterplatten oder dergl. gelöst, die durch die in dem kennzeichnenden Teil des Patentanspruches 1 angegebenen Merkmale gekennzeichnet ist.

Ein wesentlicher Vorteil der Erfindung besteht darin, dass durch sie die Verwendung von federlosen und in der Längsrichtung einen konstanten Durchmesser aufweisenden Stiften bzw. Starrstiften ermöglicht wird. Dabei liegen die Kosten zur Herstellung derartiger Starrstifte um etwa 90 % - 95 % niedriger als die Kosten zur Herstellung von federnden Prüfstiften und etwa 70 % niedriger als die Kosten zur Herstellung von Starrstiften, die in der Längsrichtung keinen konstanten Durchmesser aufweisen.

Vorteilhafterweise ermöglicht die Erfindung eine wirtschaftliche Aufbewahrung von für spezielle Leiterplattenkonfigurationen aufgebauten Vorrichtungen bzw. Adaptern, weil die Herstellungskosten für die Prüfstifte sehr niedrig sind. Die einmal aufgebauten Adapter müssen daher nicht demontiert werden und stehen für eine Wiederverwendung direkt zur Verfügung.

Vorteilhafterweise müssen die konturlosen Prüfstifte der vorliegenden Vorrichtung keine Bereiche aufweisen, an denen der Durchmesser kleiner ist als der Durchmesser der zur Kontaktierung erforderlichen Fläche. Die Stabilität der Prüfstifte wird daher lediglich durch die Grösse dieser Kontaktfläche bestimmt.

Ein weiterer Vorteil der Erfindung besteht darin, dass die einzelnen Prüfstifte beliebige und zudem an beiden Enden dieselben Kopfformen aufweisen können. Dadurch wird eine preiswerte Herstellung der Prüfstifte ermöglicht.

Im folgenden werden die Erfindungen und deren Ausgestaltungen im Zusammenhang mit den Figuren näher erläutert. Es zeigt:

Fig. 1 bis 3 in schematischer Darstellung Ausführungsformen der vorliegenden Vorrichtung;

Fig. 4 eine in eine Durchkontaktierung einer Leiterplatte eingreifende Spitze eines Prüfstiftes;

Fig. 5 eine an einem Anschlusspad einer Leiterplatte angreifende Spitze eines Prüfstiftes; und

Fig. 6 die in die trichterförmige Ausnehmung eines Kontaktelementes des Rasterfeldes eingreifende Spitze eines Prüfstiftes.

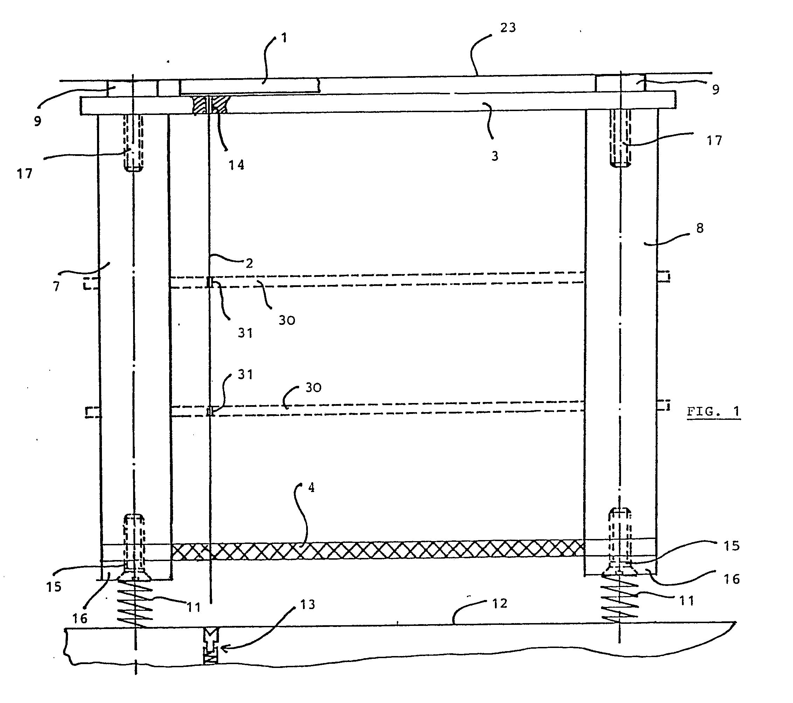

Gemäss Fig. 1 besteht eine einfache Ausführungsform der vorliegenden Vorrichtung zum elektronischen Prüfen von Leiterplatten 1 und dergleichen im wesentlichen aus einer Maskenplatte 3, einer parallel zur Maskenplatte 3 angeordneten und von dieser beabstandeten elastischen Platte bzw. Einlage 4, zwei Abstandshaltern 7, 8, die sich senkrecht zur Zeichenebene erstrecken und die Maskenplatte 3 und die elastische Platte 4 voneinander beabstandet halten, Prüfstiften 2, die in der Richtung der Normalen zur elastischen Platte 4 verlaufen, vorzugsweise federnden Einrichtungen 11, die ein federndes Andrücken der Vorrichtung an die Rasterplattenebene 12 eines Rasterfeldes ermöglichen, und vorzugsweise Distanz-Anpass-Elemente 9, die an der der elastischen Platte 4 abgewandten Seite der Maskenplatte 3 angeordnet sind und deren Dicke geringfügig grösser ist als die Dicke der zu prüfenden Leiterplatten 1.

In der Rasterplatte 12 sind die schematisch dargestellten und mit 13 bezeichneten, in ihrer Längsrichtung federnden Kontaktelemente an den einzelnen Rasterpunkten angeordnet. Der Aufbau derartiger Kontaktelemente 13 geht auch aus der Fig. 6 hervor. Die Prüfstifte 2 stellen Verbindungen zwischen vorgegebenen Kontaktelementen 13 und vorgegebenen Durchkontaktierungen bzw. Anschlusspads einer Leiterplatte 1 her. Der Einfachheit halber ist in der Fig. 1 nur ein einziger Prüfstift 2 dargestellt. Die Prüfstifte 2 verlaufen durch Durchgangsbohrungen 14 der Maskenplatte 3, die vorzugsweise aus Plexiglas besteht. Diese Durchgangsbohrungen 14 sind dann, wenn die Durchkontaktierungen bzw. Anschlusspads der Leiterplatte 1 dem Raster der Rasterplatte 12 entsprechen, so angeordnet, dass sie ebenfalls diesem Raster entsprechen. In den Fällen, in denen die Anschlusspads bzw. die Durchgangsbohrungen der Leiterplatte 1 nicht rastergebunden sind, sind die Durchgangsbohrungen 14 der Verteilung der Durchkontaktierungen bzw. Anschlusspads entsprechend angeordnet. Durch die elastische Platte 4, die fest am Umfang der durch sie hindurchgesteckten Prüfstifte 2 anliegt, wird verhindert, dass die Prüfstifte 2 aus der Vorrichtung herausfallen können. Die elastische Platte 4 ist so beschaffen, dass sie bei der geforderten Elastizität eine hinreichende Stabilität aufweist, so dass sie wie eine stabile Platte an der Vorrichtung befestigbar ist. Durch die Elastizität der Platte 4 wird erreicht, dass durch sie hindurchgesteckte Prüfstifte 2 festgehalten werden, weil das die Stifte umgebende Material der Platte 4 elastisch gegen den Umfang der Stifte drückt. Die elastische Platte 4 besteht vorzugsweise aus einem relativ steifen Elastomermaterial, insbesondere aus einem in geeigneter Weise verstärkten Schaummaterial. Sie wird durch Befestigungseinrichtungen, die beispielsweise aus in den Abstandshaltern 7, 8 verschraubbaren Elementen 15 und einer Gegendruckscheibe 16 bestehen können, an den Abstandshaltern 7, 8 befestigt. Dabei wird die elastische Platte 4 durch die Druckscheiben 16 gegen die ihr zugewandten Enden der Abstandshalter 7, 8 gedrückt. Die Maskenplatte 3 wird vorzugsweise ebenfalls durch Schraubelemente 17 an den Abstandshaltern 7, 8 verschraubt, wobei der Schaft dieser Schraubelemente jeweils durch eine Bohrung der Maskenplatte 3 hindurchgreift und der über den Randbereich dieser Bohrung greifende Kopf der Schraubelemente 17 in axialer Richtung so bemessen ist, dass er das bereits erwähnte Distanz-Anpass-Element 9 bildet.

An der der Rasterplattenebene 12 zugewandten Seite der Abstandshalter können vorzugsweise federnde Einrichtungen 11 vorgesehen sein, die beispielsweise aus Schraubenfedern oder aus Blöcken bestehen können, die aus einem federnden Material gebildet sind. Dabei ist vorzugsweise senkrecht zur Zeichenebene der Fig. 1 gesehen wenigstens an jedem Ende eines Abstandshalters 7 bzw. 8 eine federnde Einrichtung 11 vorgesehen. Die Funktion dieser federnden Einrichtung wird später noch erläutert.

Die zuvor beschriebene Vorrichtung wird derartig mit Prüfstiften 2 bestückt bzw. beladen, dass für jede herzustellende Verbindung zwischen einem Kontaktelement 13 der Rasterplatte 12 und einer zugeordneten Durchkontaktierung bzw. Anschlusspad der Leiterplatte 1 ein Prüfstift 2 in eine entsprechende Durchgangsbohrung 14 der Maskenplatte 3 eingeführt und durch die elastische Platte 4 hindurchgesteckt wird. Wie schon erwähnt, wird ein derart eingeführter Prüfstift 2 auf Grund der fest an seinem Umfang anliegenden elastischen Platte 4 in der Vorrichtung festgehalten, so dass er nicht aus dieser herausfallen kann. Zur Erleichterung des gezielten Einstechens von bestimmten Prüfstiften 2 in die elastische Platte 4 kann eine plattenartige Schablone (nicht dargestellt), die entsprechend dem Raster der Rasterplatte 12 Durchgangsbohrungen aufweist, auf die elastische Platte 4 zum Einbringen der Prüfstifte 2 in einer vorgegebenen Position aufgelegt werden.

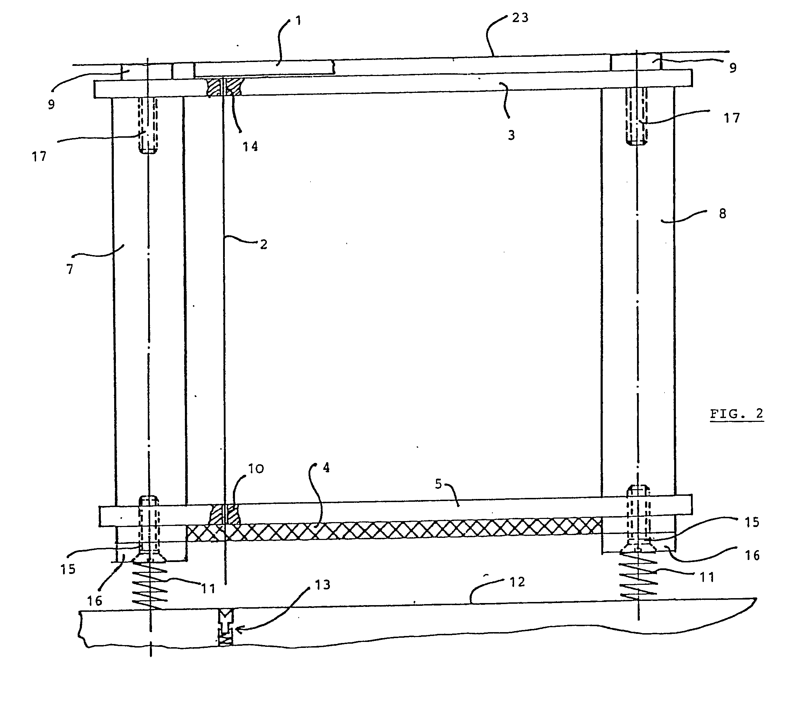

Aus der Fig. 2 geht eine Weiterbildung der Erfindung hervor, bei der die zuvor genannte aufsetzbare Schablone durch eine Führungsplatte 5 ersetzt ist, wobei diese Führungsplatte 5 fest an den Abstandshaltern 7, 8 derart angeordnet ist, dass sie sich oberhalb der elastischen Platte bzw. Einlage 4 befindet und parallel zu dieser verläuft. Die obere Führungsplatte 5 kann entsprechend dem vollen Raster der Rasterplatte 12 Durchgangsbohrungen 10 aufweisen, durch die die einzelnen Prüfstifte 2 beim Beladen der Vorrichtung hindurchgeführt werden. Vorzugsweise ist die obere rastergebundene Führungsplatte 5 an den Abstandshaltern 7, 8 mit der Hilfe der im Zusammenhang mit der Fig. 1 bereits erwähnten Befestigungselemente 15 verschraubt. Die Durchgangsbohrungen 10 können auch so in die obere Führungsplatte 5 eingebracht werden, dass sie lediglich einem für eine spezielle Leiterplatte 1 erforderlichen Teilraster entsprechen.

Für spezielle Leiterplatten beladene bzw. mit Prüfstiften 2 bestückte Vorrichtungen dieser Art können dadurch zur Wiederverwendung aufbewahrt bzw. gelagert werden, dass sie in geeignete Halteeinrichtungen (nicht dargestellt) derart eingesetzt werden, dass sich die Seite der elastischen Platte 4 oben befindet. Die an der elastischen Platte 4 festgehaltenen Prüfstifte 2 können bei einer derartigen Lagerung auch dann nicht aus der Vorrichtung herausfallen, wenn die elastische Platte 4 nicht mit der Vorrichtung fest verbunden ist.

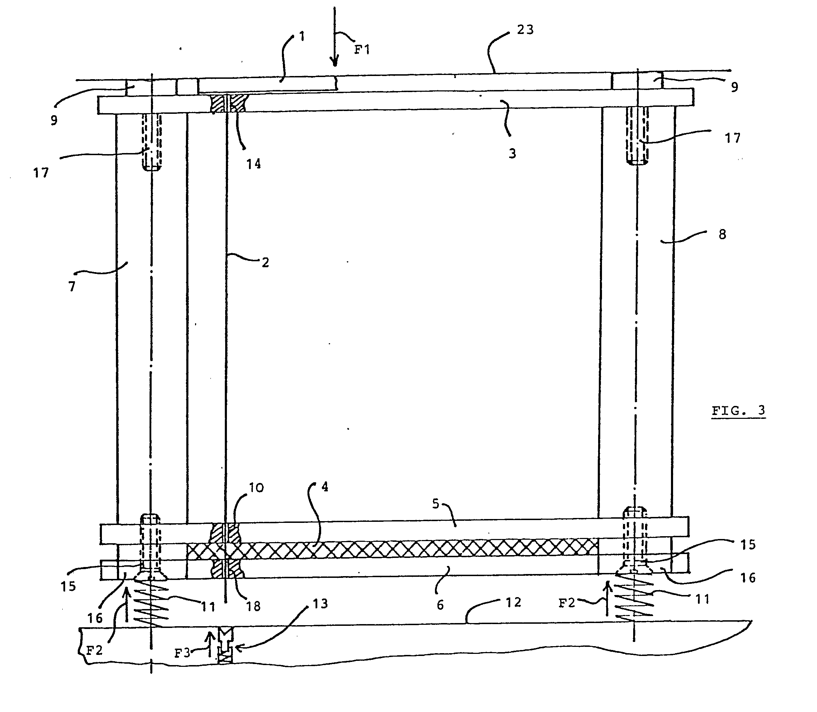

Aus der Fig. 3 geht eine Weiterbildung der Erfindung hervor, bei der auch unterhalb der elastischen Platte bzw. Einlage 4 eine weitere rastergebundene Führungsplatte 6 angeordnet ist, die vorzugsweise ebenfalls mit der Hilfe der bereits erwähnten Befestigungselemente 15 an den Abstandshaltern 7, 8 verschraubt ist. Die dem vollen Raster der Rasterplatte 12 oder dem Teilraster einer speziellen Leiterplatte 1 entsprechenden Durchgangsbohrungen dieser Platte sind mit 18 bezeichnet. In diesem Fall kann die elastische Einlage 4 die Form einer lose in dem Zwischenraum zwischen der oberen rastergebundenen Führungsplatte 5 und der unteren rastergebundenen Führungsplatte 6 angeordneten Scheibe bzw. Platte aufweisen. Ein Vorteil dieser Anordnung besteht darin, dass die lose zwischen den Führungsplatten 5, 6 befindliche elastische Einlage 4 toleranzbedingte Unebenheiten der Leiterplatte 1 dadurch aufnimmt, dass die einzelnen Prüfstifte 2 sich entsprechend diesen toleranzbedingten Unterschieden im Bereich der elastischen Einlage 4 in axialer Richtung gegeneinander verschieben. Nach dem Entfernen der Leiterplatte 1 werden diese Verschiebungen wieder ausgeglichen, da dann die elastische Einlage 4 auf Grund ihrer Elastizität wieder in ihre Ausgangslage zurückkehrt.

Bei der Anordnung der Fig. 3 kann die Lagerung von für spezielle Leiterplattenkonfigurationen mit Prüfstiften bestückten Vorrichtungen auch in der dargestellten Orientierung erfolgen, da die elastische Einlage 4 im Zwischenraum zwischen den Führungsplatten 5, 6 festgelegt ist. Bei einer Lagerung der Vorrichtung, bei der sich, wie dies zuvor beschrieben wurde, die Maskenplatte 3 unten befindet, kann die Führungsplatte 6 entfernt und für andere Zwecke verwendet werden. Die Spitzen der einzelnen kopf- und konturlosen Prüfstifte 2 können vorteilhafterweise auf beiden Seiten gleichermassen ausgebildet werden, so dass die Prüfstifte 2 vollkommen symmetrisch sind. Dadurch wird die Herstellung der Stifte weiter verbilligt. Die Prüfstifte 2 bestehen aus einem elastisch auslenkbaren federnden Material, vorzugsweise aus einem elastisch auslenkbaren Federstahlmaterial.

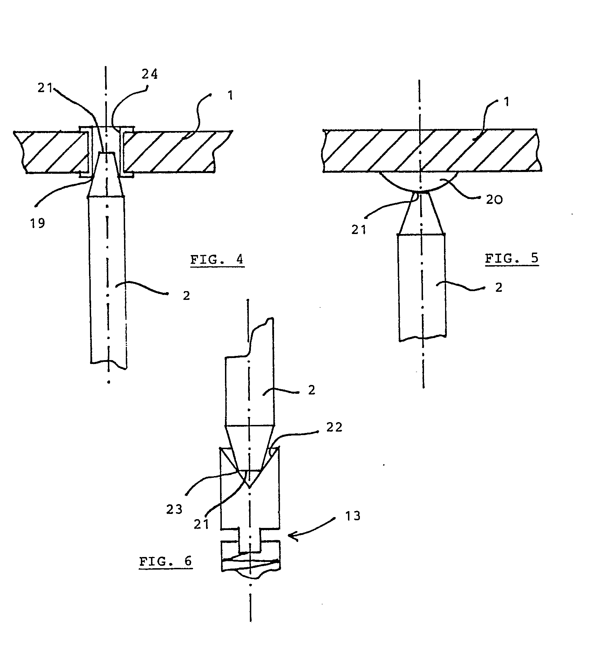

Vorzugsweise weisen die Spitzen der Prüfstifte 2 jeweils die Form eines abgeflachten Konus auf, wie dies in den Fig. 4 bis 6 dargestellt ist. Eine derartige Form der Spitzen der Prüfstifte 2 ist sowohl für die Herstellung von Kontakten zu den Durchkontaktierungen von Leiterplatten als auch zu den Anschlusspads von SMD-Leiterplatten von Vorteil. Gemäss Fig. 5 wird der Kontakt zwischen einer die Form eines abgeflachten Konus aufweisenden Spitze eines Prüfstiftes 2 und einer Durchkontaktierung 24 einer Leiterplatte 1 entlang einer Umfangslinie 19 der konusförmigen Spitze sicher hergestellt. Bei der Kontaktierung eines Anschlusspads 20 gemäss Fig. 5 mit einer derartig abgeflachten konusförmigen Spitze des Prüfstiftes 2 liegt die durch die Abflachung bewirkte Kontaktfläche 21 an der Oberfläche des Anschlusspads 20 der Leiterplatte 1 an. Da die Kontaktfläche 21 als Andruckfläche dient, kann eine mechanische Zerstörung der Oberflächenveredelung (Goldauflage) der Anschlusspads 20 verhindert werden. Im Falle einer nicht abgeflachten, sondern spitz auslaufenden Spitze der Prüfstifte 2 könnte eine derartige mechanische Zerstörung auf Grund der auftretenden Drücke erfolgen.

Da sich in den trichterförmigen Kontaktflächen 22 der bekannten Kontaktelemente 13 der Rasterplatte 12 leicht Schmutz ansammeln kann, der beispielsweise durch die Reibung des Umfanges der Prüfstifte 2 an den Innenflächen der Durchgangsbohrungen 18 der unteren Führungsplatte 6 entstehen kann, kann es bei der Verwendung von Prüfstiften 2 mit spitz auslaufenden Spitzen zu Kontaktunterbrechungen kommen, wenn sich am Boden der trichterförmigen Kontaktfläche 22 viel Schmutz ansammelt, so dass die Spitze von der trichterförmigen Fläche 22 abgehoben wird. Wenn die Spitze die beschriebene Form eines abgeflachten Konus aufweist, ist eine sichere Kontaktgabe auch bei Verschmutzungen der Kontaktelemente 13 möglich, weil an der Übergangskante 23 zwischen der Abflachung 21 und dem Konusbereich der Spitze ein ringförmiger Kontakt an der trichterförmigen Fläche 22 bewirkt wird.

Dabei erfolgt dieser ringförmige Kontakt oberhalb der Spitze der trichterförmigen Fläche 22. Durch den scharfen Kontakt an der ringförmigen Übergangskante 23 wird die Kontaktsicherheit im Vergleich zur Verwendung von spitz auslaufenden Spitzen wesentlich erhöht. Da sich statistisch gesehen der Kontaktbereich beim Einbringen der die Form eines abgeflachten Konur aufweisenden Spitzen der Prüfstifte 2 in die Kontaktelemente 13 der trichterförmigen Fläche 22 laufend geringfügig verändert, weil die Spitzen nicht immer genau senkrecht eingeführt werden, wird die Lebensdauer sowohl der Kontaktelemente 13 als auch der Prüfstifte 2 wesentlich erhöht. Vorteilhafterweise ist die durch die Abflachung erzielte Kraftverteilung durch eine geeignete Dimensionierung der Abflachung kontrollierbar.

Wenn die verwendeten Prüfstifte 2 aus einem Federstahl bestehen, weisen sie vorteilhafterweise eine optimale Biegsamkeit auf. Nach einer möglichen Auslenkung kehren sie auf Grund ihrer Elastizität in die axiale Ausgangslage sicher zurück. Dabei erfolgen federnde Auslenkungen aus der Ruhelage ausschliesslich zur Geometrieanpassung. Diese Geometrieanpassungen erlauben den Übergang von den rastergebundenen Punkten im Grundraster der Rasterplatte 12 auf die nicht rastergebundenen Anschlusspunkte der Leiterplatte 1. Ausserdem erlauben sie bei lokalen Anschlussdichten auf der Leiterplatte 1, die grösser sind als die Anschlussdichte im Grundraster der Rasterplatte 12, einen Ausgleich durch eine Auslenkung der Prüfstifte 2 bzw. einer Prüfstiftgruppe. Eine Längenveränderung erfolgt dabei nicht.

Um die möglichen Auslenkungen der Prüfstifte 2 zu begrenzen, können an den Abstandshaltern 7, 8 sich senkrecht zur Achse der Prüfstifte 2 erstreckende Zwischenplatten 30 mit Durchgangsbohrungen 31 am Bereich der zu erwartenden Auslenkungen vorgesehen werden.

Derartige Zwischenplatten 30 sind in der Fig. 1 durch unterbrochene Linien schematisch dargestellt. Dabei werden die Durchgangsbohrungen in den Zwischenplatten 30 dann, wenn die Durchgangsbohrungen 14 der Maskenplatte 3 dem Raster der Rasterplatte 12 entsprechen, ebenfalls diesem Raster entsprechend angeordnet, und dann, wenn die Durchgangsbohrungen 14 der Maskenplatte 3 nicht dem Raster der Rasterplatte 12 entsprechen, so angeordnet, dass sie eine allmähliche Anpassung zum Raster der Rasterplatte 12 ermöglichen.

Zum Zwecke der nachfolgenden Diskussion wird angenommen, dass durch die Andruckfläche 23 einer Einrichtung, die die Leiterplatte 1 zunächst so zuführt, dass sie eine vorgegebene Position einnimmt, eine Kraft F1 (Fig. 3) ausgeübt wird. Diese Kraft F1 wird dann einerseits direkt über die Distanz-Anpass-Elemente 9 auf die Abstandshalter 7, 8 übertragen. Der Kraft F1 wirken die Kräfte F2 der federnden Einrichtungen 11 entgegen. Andererseits wird die Kraft F1 auch auf die Leiterplatte 1 und von dieser auf die Prüfstifte 2 übertragen. Über die Prüfstifte 2 wirken die Kräfte F3 der federnden Kontaktelemente 13 entgegen. Dadurch, dass die Kraft F1 der Andruckfläche 23 infolge der Vorsehung der Anpassstücke 9 sowohl auf die Leiterplatte 1 als auch auf die Abstandshalter 7, 8 und die damit verbundenen Teile bzw. Platten einwirkt, werden die Prüfstifte 2 gegen die Kraft F3 der federnden Kontaktelemente 13 um denselben Weg verschoben, wie die Abstandshalter 7, 8 und die damit verbundenen Teile.

Dadurch wird vorteilhafterweise bewirkt, dass in den Durchgangsbohrungen 14 der Maskenplatte 3, gegebenenfalls den Durchgangsbohrungen 31 der Zwischenplatten 30 (Fig. 1) und gegebenenfalls den Durchgangsbohrungen 10, 18 der oberen und unteren Führungsplatten 5, 6 kein Abrieb am Innenumfang der Durchgangsbohrungen erfolgt, weil keine Relativbewegung zwischen den Prüfstiften 2 und den genannten Platten auftritt.

Dadurch, dass die elastische Platte oder Folie bzw. Einlage sich eng an den Umfang des Prüfstiftes anschmiegt, wird ein guter Schutz gegen das Durchfallen von Schmutzteilchen und dgl., die von den Prüfobjekten gegebenenfalls durch die Durchgangsbohrungen der Auslenkplatte, der Zwischenplatten und der oberen Führungsplatte herabfallen können, bewirkt. Diese Schmutzteilchen sammeln sich nämlich an der elastischen Platte an.

Bei der Verwendung einer aus einem Hartschaummaterial bestehenden elastischen Platte 4 ist es denkbar, die Platte 4 vor dem Einbringen der Prüfstifte 2 vorzubohren.

Die bei der vorliegenden Vorrichtung verwendbaren konturlosen Prüfstifte 2 eigenen sich besonders gut zur Bedienung durch ein automatisches CAF-Gerät, weil sie aufgrund ihrer Konturlosigkeit besonders einfach zu erfassen sind. In derartigen CAF-Geräten (computer aided fixuring) werden aus den für die jeweiligen Leiterplatten vorliegenden Bohrdaten Bohrdaten für die Maskenplatte und gegebenenfalls für die rastergebundenen Führungsplatten ermittelt. Bei der Verwendung einer automatischen Maschine zur Bestückung mit Prüfstiften können aus den Bohrdaten für die Leiterplatte gleichzeitig auch die Bestückungsdaten ermittelt werden.

**Patentansprüche**

1. Vorrichtung zum elektronischen Prüfen von Leiterplatten mit einer Vielzahl von im wesentlichen parallel verlaufenden Prüfstiften (2), die jewels eine elektrische Verbindung zwischen einem federnden Kontaktelement (13) von federnden Kontaktelementen, die dem vollen Raster des Rasterfeldes einer Rasterplatte (12) entsprechen, gegen die die Vorrichtung drückbar ist, und einem Kontaktbereich (20, 24) einer parallel zur Rasterplatte positionierten Leiterplatte (1) herstellen, und mit einer Maskenplatte (3) mit Durchgangsbohrungen (14), die senkrecht zu den Prüfstiften (2) verläuft und auf einer der Leiterplatte (1) zugewandten Seite angeordnet ist, wobei durch die Durchgangslöcher (14) die Prüfstifte (2) derart verlaufen, dass ihre einen Spitzen durch sie hindurchragen und in Berührung zu Kontaktbereichen (20, 24) der in einer vorgegebenen Position angeordneten Leiterplatte (1) gelangen, dadurch gekennzeichnet, dass von der Maskenplatte (3) beabstandet eine elastische Platte (4) im wesentlichen parallel zur Maskenplatte (3) angeordnet ist, durch die die in Längsrichtung nicht federnden Prüfstifte (2) derart verlaufen, sie aufgrund der Elastizität des Matrials der elastischen Platte (4) an dieser festgehalten werden.

2. Vorrichtung nach Anspruch 1, dadurch gekennzeichnet, dass die Durchgangsbohrungen (14) der Maskenplatte (3) dem Raster der Rasterplatte (12) entsprechen oder nicht rastergebunden vorgesehen sind.

3. Vorrichtung nach Anspruch 1 oder 2, dadurch gekennzeichnet, dass die Prüfstifte (2) in der Längsrichtung einen konstanten Durchmesser aufweisen.

4. Vorrichtung nach einem der Ansprüche 1 bis 3, dadurch gekennzeichnet, dass die Prüfstifte (2) aus einem elastisch auslenkbaren Federstahlmaterial bestehen.

5. Vorrichtung nach einem der Ansprüche 1 bis 4, dadurch gekennzeichnet, dass an der der Leiterplatte (1) zugewandten Seite der Maskenplatte (3) zwischen einer die Leiterplatte (1) gegen die Spitzen der Prüfstifte drückenden Andruckfläche (23) und der Maskenplatte (3) mit der Maskenplatte (3) verbundene Distanz-Anpass-Elemente (9) vorgesehen sind, deren Dicke im wesentlichen der Dicke der Leiterplatte (1) entspricht, so dass die Leiterplatte (1) und die Prüfstifte (2) einerseits und die Distanz-Anpass-Elemente (9) und die damit verbundenen Teile andererseits durch die Kraft (F1) der Andruckfläche (23) gleichlaufend bewegt werden.

6. Vorrichtung nach Anspruch 5, dadurch gekennzeichnet, dass die Maskenplatte (3) und die elastische Platte (4) durch Abstandshalter (7, 8) voneinander beabstandet sind und dass die Distanz-Anpass-Elemente (9) an der einen Seite der Abstandshalter (7, 8) befestigt sind.

7. Vorrichtung nach Anspruch 6, dadurch gekennzeichnet, dass an der anderen Seite der Abstandshalter (7, 8) federnde Einrichtungen (11) vorgesehen sind, gegen deren Kraft die Vorrichtung gegen die Rasterplatte (12) drückbar ist.

8. Vorrichtung nach Anspruch 7, dadurch gekennzeichnet, dass als federnde Einrichtungen (11) Schraubenfedern vorgesehen sind.

9. Vorrichtung nach Anspruch 7, dadurch dadurch gekennzeichnet, dass als federnde Einrichtungen (11) Blöcke aus einem federnden Material vorgesehen sind.

10. Vorrichtung nach einem der Ansprüche 1 bis 9, dadurch gekennzeichnet, dass die einen und/oder anderen Spitzen der Prüftstifte (2) jeweils die Form eines abgeflachten Konus aufweisen.

11. Vorrichtung nach einem der Ansprüche 1 bis 10, dadurch gekennzeichnet, dass an der der Maskenplatte (3) zugewandten Seite der elastischen Platte (4) eine obere Führungsplatte (5) mit Durchgangsbohrungen (13) für die Prüfstifte (2) vorgesehen ist, und dass die Durchgangsbohrungen (13) dem vollen Raster der Rasterplatte (12) oder einem ausgewählten Teilraster entsprechend vorgesehen sind.

12. Vorrichtung nach Anspruch 11, dadurch gekennzeichnet, dass die obere Führungsplatte (5) an den Abstandshaltern (7, 8) befestigt ist.

13. Vorrichtung nach Anspruch 11 oder 12, dadurch gekennzeichnet, dass die elastische Platte (4) und die obere Führungsplatte (5), an den Abstandshaltern (7, 8) befestigt sind.

14. Vorrichtung nach einem der Ansprüche 11 bis 13, dadurch gekennzeichnet, dass von der oberen Führungsplatte (5) beabstandet eine untere Führungsplatte (6) mit Durchgangsbohrungen (14) für die Prüfstifte (2) vorgesehen ist, die dem vollen Raster der Rasterplatte (12) oder einem ausgewählten Teilraster entsprechen, und dass die elastische Platte (4) in der Form einer elastischen Einlage zwischen der oberen Führungsplatte (5) und der unteren Führungsplatte (6) vorgesehen ist.

15. Vorrichtung nach Anspruch 14, dadurch gekennzeichnet, dass die Dicke der elastischen Einlage (4) kleiner ist als der Abstand zwischen der oberen Führungsplatte (5) und der unteren Führungsplatte (6).

16. Vorrichtung nach einem der Ansprüche 1 bis 15, dadurch gekennzeichnet, dass die elastische Platte bzw. die elastische Einlage (4) aus einem Hartschaummaterial oder einer Gummibahn besteht.

17. Vorrichtung nach einem der Ansprüche 5 bis 16, dadurch gekennzeichnet, dass die Maskenplatte (3) durch bolzenartige Einrichtungen an den Abstandshaltern (7, 8) befestigt, ist, dass der Schaft (17) einer bolzenartigen Einrichtung durch eine in der Maskenplatte (3) vorgesehenen Bohrung verläuft und in den Abstandshaltern (7, 8) befestigt ist und dass der Kopf der bolzenartigen Einrichtung das Distanz-Anpass-Element (9) bildet.

18. Vorrichtung nach einem der Ansprüche 1 bis 17, dadurch gekennzeichnet, dass die Maskenplatte (3) aus Plexiglas besteht.

19. Vorrichtung nach einem der Ansprüche 1 bis 18, dadurch gekennzeichnet, dass zwischen der Maskenplatte (3) und der elastischen Platte (4) bzw. der oberen Führungsplatte (5) wenigstens eine Zwischenplatte (30) parallel zur Maskenplatte (3) angeordnet ist, deren Durchgangsöffnungen (31) dem Raster der Rasterplatte (12) entsprechen, wenn das Raster der Maskenplatte (3) diesem Raster entspricht, oder so angeordnet sind, dass sie einen allmählichen Übergang zwischen dem Raster der Rasterplatte (12) und den nicht rastergebundenen Durchgangsbohrungen (14) der Maskenplatte (3) bilden.

## Claims

1. An apparatus for electronically testing circuit boards with a plurality of substantially parallel test pins (2) for making a respective electrical connection between a resilient contact element (13) of resilient contact elements, corresponding to the complete grid of the raster field of a raster plate (12) against which the apparatus can be pressed, and a contact region (20, 24) of a circuit board (1) positioned in parallel with the raster plate, and with a mask plate (3) with passages (14) which runs perpendicularly to the test pins (2) and is arranged on a side facing the circuit board (1), the test pins (2) running through the passages (14) in such a way that one of their tips projects through them and strikes contact regions (20, 24) of the circuit board (1) arranged in a predetermined position, characterised in that, at a distance from the mask plate (3) there is arranged an elastic plate (4) substantially parallel to the mask plate (3), through which the test pins (2) which are longitudinally rigid run in such a way that they are held on said elastic plate owing to the elasticity of the material of the elastic plate (4).

2. An apparatus according to claim 1, characterised in that the passages (14) in the mask plate (3) correspond to the grid of the raster plate (12) or are not bound to the grid.

3. An apparatus according to claim 1 or 2, characterised in that the test pins (2) have a constant diameter in the longitudinal direction.

4. An apparatus according to one of claims 1 to 3, characterised in that the test pins (2) are composed of an elastically deflectable sprung steel material.

5. An apparatus according to one of claims 1 to 4, characterised in that, on the side of the mask plate (3) facing the circuit board (1) between a pressing surface (23) pressing the circuit board (1) against the tips of the test pins and the mask plate (3), there are provided spacer adaptor elements (9) wich are connected to the mask plate (3) and whose thickness substantially corresponds to the thickness of the circuit board (1) so that the circuit board (1) and the test pins (2) on the one hand and the spacer adaptor elements (9) and the parts connected thereto on the other hand are moved equally by the force (F1) exerted by the pressing surface (23).

6. An apparatus according to claim 5, characterised in that the mask plate (3) and the elastic plate (4) are spaced from one another by spacer members (7, 8) and in that the spacer adaptor elements (9) are fixed on one side of the spacer members (7, 8).

7. An apparatus according to claim 6, characterised in that, on the other side of the spacer members (7, 8) there are provided resilient means (11) against whose force the apparatus can be pressed against the raster plate (12).

8. An apparatus according to claim 7, characterised in that coil springs are provided as resilient means (11).

9. An apparatus according to claim 7, characterised in that blocks of a resilient material are provided as resilient means (11).

10. An apparatus according to one of claims 1 to 9, characterised in that one and/or other tips of the test pins (2) has the respective shape of a truncated cone.

11. An apparatus according to one of claims 1 to 10, characterised in that, on the side of the elastic plate (4) facing the mask plate (3), there is provided an upper guide plate (5) with passages (13) for the test pins (2), and in that the passages (13) are provided over the full grid of the raster plate (12) or over a selected portion of the grid.

12. An apparatus according to claim 11, characterised in that the upper guide plate (5) is fixed on the spacer members (7, 8).

13. An apparatus according to claim 11 or 12, characterised in that the elastic plate (4) and the upper guide plate (5) are fixed on the spacer members (7, 8).

14. An apparatus according to one of claims 11 to 13, characterised in that, spaced from the upper guide plate (5), there is provided a lower guide plate (6) with passages (14) for the test pins (2) which correspond to the full grid of the raster plate (12) or to a selected portion of the grid, and in that the elastic plate (4) is provided in the form of an elastic inlay between the upper guide plate (5) and the lower guide plate (6).

15. An apparatus according to claim 14, characterised in that the thickness of the elastic inlay (4) is smaller than the distance between the upper guide plate (5) and the lower guide plate (6).

16. An apparatus according to one of claims 1 to 15, characterised in that the elastic plate or the elastic inlay (4) is composed of a rigid foam material or a rubber web.

17. An apparatus according to one of claims 5 to 16, characterised in that the mask plate (3) is fixed on the spacer members (7, 8) by bolt-like members, in that the shank (17) of a bolt-like member runs through a bore provided in the mask plate (3) and is fixed in the spacer members (7, 8) and in that the head of the bolt-like member forms the spacer adaptor element (9).

18. An apparatus according to one of claims 1 to 17, characterised in that the mask plate (3) is composed of plexiglass.

19. An apparatus according to one of claims 1 to 18, characterised in that between the mask plate (3) and the elastic plate (4) or the upper guide plate (5) there is arranged at least one intermediate plate (3) parallel to the mask plate (3), whose passages (31) correspond to the grid of the raster plate (12) if the grid of the mask plate (30) corresponds to this grid, or are arranged such that they form a gradual transition between the grid of the raster plate (12) and the passages (14) of the mask plate (3) not bound to the grid.

**Revendications**

1. Dispositif d'essai électronique de circuits imprimés, comportant plusieurs broches de test (2) disposées parallèlement, qui établissent une liaison électrique entre un élément de contact à ressort (13) d'éléments de contact à ressort qui correspondent à la trame complète du champ de trame d'une plaque tramée (12), contre laquelle le dispositif peut être appliqué, et une zone de contact (20, 24) d'un circuit imprimé (1) placé parallèlement à la plaque tramée, et une plaque de masquage (3) comportant des trous de passage (14), qui est perpendiculaire aux broches de test (2) et est agencée sur une des faces orientées vers le circuit imprimé (1), les broches de test (2) traversant les trous de passage (14), de telle sorte qu'une de leurs pointes y est en saillie et atteint des zones de contact (20, 24) du circuit imprimé (1) placé dans une position prédéterminée, ce dispositif étant caractérisé par le fait qu'à une certaine distance de la plaque de masquage (3) est disposée un plaque souple (4) parallèlement à la plaque de masquage (3), à travers laquelle passent les broches de test sans ressort (2) de telle sorte qu'en raison de la nature de l'élasticité de la matière de la plaque souple (4), elles sont maintenues par celle-ci.

2. Dispositif suivant la revendication 1, caractérisé par le fait que les trous de passage (14) de la plaque de masquage (3) correspondent à la trame de la plaque tramée (12) ou ne sont pas prévus en correspondance avec cette trame.

3. Dispositif suivant la revendicatione 1 ou 2, caractérisé par le fait que les broches de test (2) présentent longitudinalement un diamètre constant.

4. Dispositif suivant l'une des revendications 1 à 3, caractérisé par le fait que les broches de test (2) sont en acier à ressort élastique et flexible.

5. Dispositif suivant l'une des revendications 1 à 4, caractérisé par le fait qu'au niveau de la face de la plaque de masquage (3) orientée vers le circuit imprimé (1), entre une surface de pression (23) appliquant le circuit imprimé (1) contre la pointe des broches de test et la plaque de masquage (3), sont disposées des cales d'ajustement (9) reliées à la plaque de masquage (3), l'épaisseur de ces cales étant identique à celle du circuit imprimé (1), de telle sorte que le circuit imprimé (1) et les broches de test (2) d'une part, les cales d'ajustement (9) et les éléments qui y sont reliés d'autre part se déplacent uniformément sous l'effet de la force (F1) de la surface de pression (23).

6. Dispositif suivant la revendication 5, caractérisé par le fait que la plaque de masquage (3) et la plaque souple (4) sont maintenues écartées par les entretoises (7, 8) et que les cales d'ajustement (9) sont fixées à une extrémité des entretoises (7, 8).

7. Dispositif suivant la revendication 6, caractérisé par le fait qu'à l'autre extrémité des entretoises (7, 8) sont disposés des systèmes à ressort (11) à l'encontre de la force desquels le dispositif peut être appliqué sur la plaque tramée (12).

8. Dispositif suivant la revendication 7, caractérisé par le fait que les systèmes à ressort (11) sont des ressorts cylindriques.

9. Dispositif suivant la revendication 7, caractérisé par le fait que les systèmes à ressort (11) sont des blocs en matière élastique.

10. Dispositif suivant l'une des revendications 1 à 9, caractérisé par le fait qu'une ou les deux pointes des broches de test (2) présentent la forme d'un cône tronqué.

11. Dispositif suivant l'une des revendications 1 à 10, caractérisé par le fait qu'au niveau de la face de la plaque de masquage (3) orientée vers la plaque souple (4) est prévue une plaque de guidage supérieure (5) pourvue de trous de passage (13) pour les broches de test (2) et que ces trous (13) correspondent à la totalité de la trame de la plaque tramée (12) ou à une partie déterminée de cette trame.

12. Dispositif suivant la revendication 11, caractérisé par le fait que la plaque de guidage supérieure (5) est fixée aux entretoises (7, 8).

13. Dispositif suivant la revendication 11 ou 12, caractérisé par le fait que la plaque souple (4) et la plaque de guidage supérieure (5) sont fixée aux entretoises (7, 8).

14. Dispositif suivant l'une des revendications 11

à 13, caractérisé par le fait qu'à une certaine distance de la plaque de guidage supérieure (5) est prévue une plaque de guidage inférieure (6) avec trous de passage (14) pour les broches de test (2), qui correspondent à la totalité de la trame de la plaque tramée (12) ou à une partie détérminé de cette trame, et que la plaque souple (4) est prévue sous forme d'une pièce intercalaire entre la plaque de guidage supérieure (5) et la plaque de guidage inférieure (6).

15. Dispositif suivant la revendication 14, caractérisé par le fait que l'épaisseur de la plaque souple intercalaire (4) est inférieure à la distance entre la plaque de guidage supérieure (5) et la plaque de guidage inférieure (6).

16. Dispositif suivant l'une des revendications 1 à 15, caractérisé par le fait que la plaque souple intercalaire (4) est constituée par de la mousse rigide ou une bande de caoutchouc.

17. Dispositif suivant l'une des revendications 5 à 16, caractérisé par le fait que la plaque de masquage (3) est fixée aux entretoises (7,8) par des systèmes à cheville, que la tige d'un système à cheville passe par un trou de passage de la plaque de masquage (3) et est fixée dans les entretoises (7, 8), et que la tête du système à cheville forme la cale d'ajustement (9).

18. Dispositif suivant l'une des revendications 1 à 17, caractérisé par le fait que la plaque de masquage (3) est en plexiglas.

19. Dispositif suivant l'une des revendications 1 à 18, caractérisé par le fait qu'entre la plaque de masquage (3) et la plaque souple (4) ou la plaque de guidage supérieure (5), et parallèlement à la plaque de masquage (3), est prévue au moins une plaque intermédiaire (30) dont les trous de passage correspondent à la trame de la plaque tramée (12) lorsque la trame de la plaque de masquage (3) correspond à cette trame, ou sont disposés de telle sorte qu'ils forment une transition progressive entre la trame de la plaque tramée (12) et les trous de passage (14) de la plaque de masquage (3).

FIG. 1

FIG. 2

FIG. 3

0 215 146

FIG. 4

FIG. 5

FIG. 6